# EUROPEAN PATENT SPECIFICATION

(11) **EP 0 493 054 B1**
(45) Date of publication and mention of the grant of the patent: **16.09.1998**
(21) Application number: 91311920.2
(22) Date of filing: 23.12.1991
(51) Int. Cl.: G03G 5/05

(54) **Charge transporting layers formed from curable compositions**
Ladungstransportschichten gebildet aus härtbaren Zusammensetzungen
Couches de transport de charge formées de compositions durcissables

(30) Priority: 27.12.1990 US 634586
(43) Date of publication of application: 01.07.1992
(73) Proprietor: XEROX CORPORATION, Rochester, New York 14644 (US)
(72) Inventor: Stolka, Milan, Fairport, New York 14450 (US); Morrison, Ian D., Webster, New York 14580 (US); Hsieh, Bing R., Webster, New York 14580 (US)
(74) Representative: Pike, Christopher Gerard

(56) References cited:
- GB-A- 1 188 330
- US-A- 4 883 731
- US-A- 4 988 595
- PATENT ABSTRACTS OF JAPAN vol. 13, no. 276 (P-890)(3624) 26 June 1989; & JP-A-1 066 656 ( SEIKO EPSON CORP. ) 13 March 1989
- XEROX DISCLOSURE JOURNAL vol. 4, no. 6, December 1979, USA page 711; JAN BARES: 'photoreceptor preparation'
- RESEARCH DISCLOSURE no. 269, September 1986, EMSWORTH, HAMPSHIRE, GB page 570; ANONYMOUSLY: 'preparation of photoconductor structures using uv curing'
- I.B.M. TECHNICAL DISCLOSURE BULLETIN vol. 29, no. 5, October 1986, NEW YORK, US page 2256; 'preparation of a charge-generation layer using electron beam curing'

## Description

The present invention relates to a process for preparing a photoreceptor whereby the charge transport layer is coated on the charge generating layer deposited on a substrate without the use of solvent.

In electrophotography, an electrophotographic imaging member containing a photoconductive insulating layer or layers is imaged by first uniformly electrostatically charging its surface. The imaging member is then exposed to a pattern of activating electromagnetic radiation such as light. The radiation selectively dissipates the charge in the illuminated areas of the photoconductive insulating layer while leaving behind an electrostatic latent image in the non-illuminated areas. This electrostatic latent image may then be developed to form a visible image by depositing finely divided electroscopic marking particles on the surface of the photoconductive insulating layer. The resulting visible image may then be transferred from the electrophotographic imaging member to a support such as paper. This imaging process may be repeated many times with reusable photoconductive insulating layers.

An electrophotographic imaging member may be a homogeneous layer of a single material such as vitreous selenium or may be a composite layer containing a photoconductor and another material, or may be several layers. One type of composite imaging material comprises a layer of finely divided particles of a photoconductive inorganic compound dispersed in an electrically insulating organic resin binder. U.S. Patent No. 4,265,990 discloses a layered photoreceptor having separate photogenerating and charge transport layers. The photogenerating layer is capable of photogenerating holes and injecting the photogenerated holes into the charge transport layer.

GB-B-1,188,300 discloses a method of forming an electrophotographic plate which includes a photoconductive substance dispersed in a resin matrix, the resin matrix having been formed from a "solventless polymer system", i.e. a liquid composition containing material, such as a monomer or pre-polymer, capable of polymerising to form a solid resin without evaporation of solvent.

IBM Technical Disclosure Bulletin Vol. 29, No. 5, Oct. 1986, discloses a one step process for preparing a charge generation layer, which uses no solvents. A dye is dispersed a monomeric acrylate/methacrylate; the dispersion is applied to a substrate with a doctor blade; and the layer is then exposed to a 175kV electron beam under i ntrogen at atmospheric pressure, to cure it.

Research Disclosure, September 1986, No. 269, p.570 discloses a process for preparing photoconductor structures. A charge generation layer is produced without using solvents, by dispersing a dye-like chlorodiane blue in a commercial monomeric acrylate and adding a photoinitiator. The dispersion is then applied to a substrate by doctor blade and then exposed to UV light under nitrogen at 1 atm to cure.

Patent Abstracts of Japan JP-A-1-66656, Vol.13, No.276 (p-890)(3624), discloses a method of forming an electrophotographic sensitive body, comprising: mixing charge transfer material, a condensable monomer and an additionally polymerizable monomer, to form a coating solution; coating a charge generating layer 2 with the coating solution, while illuminating the upper surface of the coating layer with a high pressure mercury lamp; polymerizing the coating solution at a prescribed temperature; and forming the charge transfer layer 1 made from the condensable monomer and the additionally polymerizable monomer in a prescribed thickness.

US-A-4,883,731 discloses an imaging system employing an imaging member providing a xeroprinting master in a xeroprinting process (i.e. "an electrostatic printing process for printing multiple copies from a master plate or cylinder"). For this purpose, the imaging member comprises a substrate and an electrically insulating softenable (i.e. rendered more permeable, e.g. by heating) layer on the substrate, the softenable layer having migration marking material (which is susceptible to migration towards the substrate upon imagewise exposure to light, while the layer is temporarily softened) locked at or near the outer surface of the softenahle layer.

In "Research Disclosure", no.269, sept 86, p. 570, the preparation of photoconductor structures using UV curing is disclosed. The charge generating layer is applied by photoillumination the coating solution.

The present invention provides a process for preparing a photoreceptor as claimed in claim 1.

The charge transport layer of an imaging member may comprise any suitable transparent insulating organic polymer or non- polymeric material charge transport material capable of supporting the injection of photogenerated holes and electrons from the charge generating layer and allowing the transport of these holes or electrons through the organic layer to selectively discharge the surface layer.

An especially preferred transport layer employed in multilayer photoconductors comprises from about 25% to about 75% by weight of at least one charge transporting aromatic amine compound, and about 75% to 25% of a polymeric film forming resin in which the aromatic amine is soluble. The charge transport layer is preferably formed from a mixture of an aromatic amine compound of one or more compounds having the general formula: 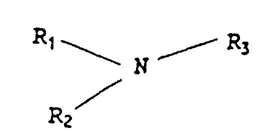 wherein R₁ and R₂ are aromatic groups selected from the group consisting of substituted or unsubstituted phenyl group, naphthyl group, and polyphenyl group and R₃ is selected from the group consisting of a substituted or unsubstituted aryl group, alkyl groups having one to eighteen carbon atoms, and cycloaliphatic compounds having from three to eighteen carbon atoms. The substitutes should be free of electron withdrawing groups such as NO₂ groups and CN groups. Typical aromatic amine compounds that are represented by this structural formula include:
i. Triphenyl amines such as: 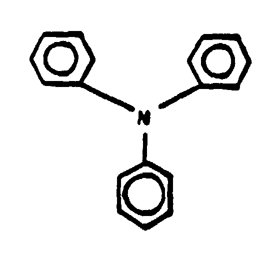
ii. Bis and polytriarylamines such as: 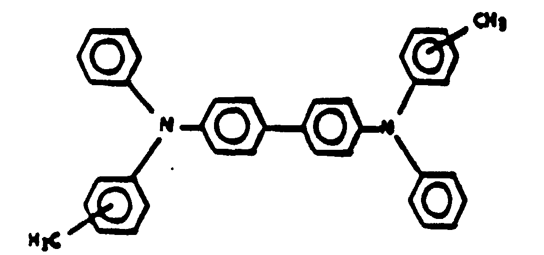
iii. Bis arylamine ethers such as: 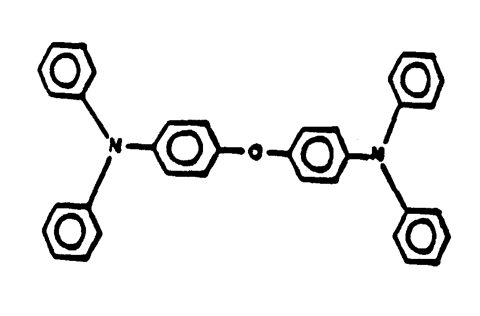 and
iv. Bis alkyl-arylamines such as:

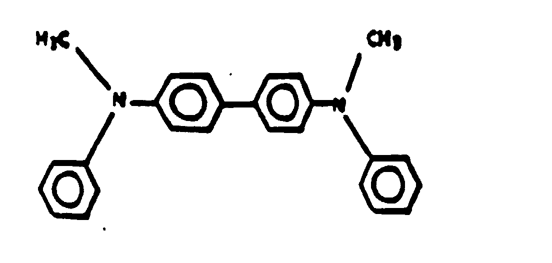

A preferred aromatic amine compound has the general formula: 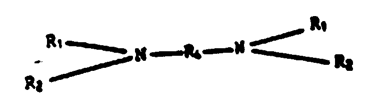 wherein R₁ and R₂ are defined above and R₄ is selected from the group consisting of a substituted or unsubstituted biphenyl group, diphenyl ether group, alkyl group having from one to eighteen carbon atoms, and cycloaliphatic group having from three to twelve carbon atoms. The substitutes should be free of electron withdrawing groups such as NO₂ groups and CN groups.

Examples of charge transporting aromatic amines represented by the structural formula of above include triphenylmethane, bis (4-diethylamine-2-methylphenyl)phenylmethane; 4'-4"- bis(diethylamino)-2'2"-dimethyltriphenylmethane; N, N'-bis(alkylphenyl)-[1,1'-biphenyl]-4,4'-diamine wherein the alkyl is, for example, methyl, ethyl, propyl or N-butyl; N,N'-diphenyl- N,N'-bis(3" methylphenyl)-(1,1' biphenyl)-4,4'-diamine. The amines are dispersed in an inactive resin binder. Molecular weights of the amines can vary from about 20,000 to about 1,500,000.

The preferred electrically inactive resin materials are polycarbonate resins having a molecular weight from about 20,000 to about 120,000, more preferably from about 50,000 to about 100,000. The materials most preferred as the electrically inactive resin materials are poly(4,4'-dipropylidene-diphenylene carbonate) having a molecular weight from about 35,000 to about 40,000, available as Lexan 145 from General Electric Company; poly(4,4'-isopropylidene-diphenylene carbonate) with a molecular weight from about 40,000 to about 45,000, available as Lexan 141 from General Electric Company; a polycarbonate resin having a molecular weight of from about 50,000 to about 100,000, available as Makrolon from Farben Fabricken Bayer A.G.; a polycarbonate resin having a molecular weight of from about 20,000 to about 50,000, available as Merlon from Mobay Chemical Company; polyether carbonates; and 4,4'-cyclohexylidene diphenyl polycarbonate. Methylene chloride solvent is a desirable component of the charge transport layer coating mixture for adequate dissolving of all the components as it has a low boiling point. Other solvents that dissolve these binders include tetrahydrofuran, toluene, trichloroethylene, 1,1,2-trichloroethane, and 1,1,1-trichloroethane.

The charge transport layer of the electrophotographic imaging member is produced by dissolving the charge transporting material and the polymeric film forming resin in a volatile solvent, applying the solution by any of the usual coating techniques: e.g., spraying, dipping, roll coating, or extrusion, to form a uniform coating on the electrophotographic imaging member, and evaporating the volatile solvent. The polymeric film forming resin provides a matrix to support the charge transporting material which by itself would be too mechanically weak to be useful on an electrophotographic imaging member. The solvent provides the means by which the charge transporting material and the polymeric film forming resin can be mixed and formed into a uniform film. Therefore the combined purposes of the polymeric film forming resin and the solvent is to provide the means by which the charge transporting material can be coated and supported to provide a charge carrying path from the charge generating layer to the top surface. It is desirable to find a material that provides the function of the solvent and the polymeric film forming resin, that is, to provide a means by which the charge transporting material can be coated as a uniform layer on the charge generating layer coated on the substrate of the electrophographic imaging member and by which the charge transporting material can be made mechanically strong. It is also desirable to find a process by which the generation of volatiles is minimized or eliminated.

The liquid solution can be coated onto a film in the usual coating processes, e.g., by spray, dip, roll coating or extrusion. During the curing process, the cured liquid forms the solid matrix, the properties of which can largely be controlled by the choice of curable monomer. Thus, the curable liquid replaces both the coating solvent and the film forming polymer. The transporting molecule can be a small diamine molecule or a charge transporting polymer. If the transport molecule is a charge transporting polymer, the final coated and cured film would be an interpenetrating polymer network.

Processes in accordance with the present invention offer advantages over previous processes. The advantages include:
a) elimination of the solvent which reduces both cost and environmental impact;
b) increased mechanical strength and solvent resistance of the cured film because the curable liquid can be crosslinked using multifunctional monomers;
c) increased energy savings because curing systems require less energy than solvent drying;
d) increased adhesion between layers of the imaging member because curable liquids make intimate contact before curing;
e) decreased curl because curing can be accomplished at room temperature; and
f) increase in the class of transporting molecules because monomers are compatible with more other molecules than polymer solutions.

A process in accordance with the invention is not dependent on the use of a specific curable liquid monomer as long as: a) the monomer is miscible (compatible) with the charge transporting molecule or charge transporting polymer, and, b) the resulting polymer is also compatible with the charge transporting molecule or polymer and c) the polymerization of the curable liquid does not cause a reaction with the charge transporting material, and the monomer subjects only to addition polymerization in the presence of a cationic initiator by photo-illumination. Particularly advantageous for this purpose are monomers such as vinyl ethers, epoxies and the like, which can be polymerized by ultraviolet- light induced cationic polymerization using photoinitiators that photolyze to strong acids, but free-radically polymerizable systems are also applicable.

Appropriate initiators include cationic initiators that photolyze to strong Lewis acids, such as aryldiazonium salts of the general formula ArN₂⁺X⁻ wherein Ar is an aromatic ring such as butyl benzene, nitrobenzene, dinitrobenzene, or the like and X is BF₄, PF₆, AsF₆, SbF₆, CF₃SO₃, or the like, diaryliodonium salts of the general formula Ar₂l⁺X⁻, wherein Ar is an aromatic ring such as methoxy benzene, butyl benzene, butoxy benzene, octyl benzene, didecyl benzene, or the like, and X is an ion of low nucleophilicity, such as PF₆, AsF₆, BF₄, SbF₆, CF₃SO₃, and the like; triarylsulfonium salts of the general formula Ar₃S⁺X⁻, wherein Ar is an aromatic ring such as hydroxy benzene, methoxy benzene, butyl benzene, butoxy benzene, octyl benzene, dodecyl benzene, or the like and X is an ion of low nucleophilicity, such as PF₆, AsF₆, SbF₆, BF₄,CF₃SO₃, or the like; nonradical initiators comprising amine salts of alpha-ketocarboxylic acids, such as the tributyl ammonium salt of phenylglyoxylic acid; and the like, as well as mixtures thereof. Further photoacid generating initiators are disclosed in "The Chemistry of Photoacid Generating Compounds," by J.V. Crivello in Proceedings of the ACS Division of Polymeric Materials: Science and Engineering, VOI 61, pages 62-66, (1989), "Redox Cationic Polymerization: The Diaryliodonium Sal/Ascorbate Redox Couple," by J.V. Crivello and J.H.W. Lam in Journal of Polymer Science: Polymer Chemistry Edition, Vol. 19, pages 539-548 (1981), "Redox-Induced Cationic Polymerization: The Diaryliodonium Salt/Benzoin Redox Couple," by J.V. Crivello and J.L. Lee in Journal of Polymer Science: Polymer Chemistry Edition, Vol. 21, pages 1097-1110 (1983), "Diaryliodonium Salts as Thermal Initiators of Cationic Polymerization," by J.V. Crivello, T.P. Lockhart and J.L. Lee in Journal of Polymer Science: Polymer Chemistry Edition, Vol. 21, pages 97-109 (1983).

Further examples of suitable initiators include alpha-alkoxy phenyl ketones, O-acylated alpha-oximinoketones, polycyclic quinones, xanthones, thioxanthones, halogenated compounds such as chlorosulfonyl and chloromethyl polynuclear aromatic compounds, chlorosulfonyl and chloromethyl heterocyclic compounds, chlorosulfonyl and chloromethyl benzophenones and fluorenones, haloalkanes, alpha-halo alpha-phenylacetophenones, photoreducible dye-reducing agent redox couples, halogenated paraffins such as brominated or chlorinated parrafin, benzoin alkyl esters, cationic diborate anion complexes, anionic di-iodonium ion compounds, and anionic dye-pyrrilium compounds.

Additional examples of suitable initiators are disclosed in, for example U.S. Patent 4,683,317, U.S. Patent 4,378,277, U.S. Patent 4,279,717, U.S. Patent 4,680,368, U.S. Patent 4,443,495, U.S. Patent 4,751,102, U.S. Patent 4,334,970, "Complex Triarylsulfonium Salt Photoinitiators I. The Identification, Characterization, and Syntheses of a New Class of Triarylsulfonium Salt Photoinitiators," J.V. Crivello and J.H.W. Lam, Journal of Polymer Science: Polymer Chemistry Edition, vol. 18, 2677-2695 (1980); "Complex Triarylsulfonium Photoinitiators II. The Preparation of several New Complex Triarylsulfonium Salts and the Influence of Their Structure in Photoinitiated Cationic Polymerization," J.V. Crivello and J.H.W. Lam, Journal of Polymer Science Polymer Chemistry Edition, Vol. 18, pages 2697-2714 (1980); "Diaryliodonium Salts A New Class of Photoinitiators for Cationic Polymerization," J.V. Crivello and J.H.W. Lam, Maromolecules, Vol. 10, pages 1307-1315 (1977); and "Developments in the Design and Applications of Novel Thermal and Photochemical Initiators for Cationic Polymerization" by J.V. Crivello, J.L. Lee and D.A. Conlon in Makromol. Chem. Macromolecular symposium, vol. 13/14, pages 134-160 (1988). Particularly preferred are the diaryl iodonium salts and their derivatives, the triaryl sulfonium salts and their derivatives, and the triphenyl phosphonium salts and their derivatives, with examples of derivatives being those with alkyl, aryl, or alkoxy substituents on the aryl rings. The initiator is present in the curable liquid in any effective amount, typically from about 0.1 to about 10 percent by weight of the liquid, and preferably from about 0.1 to about 3 percent by weight of the liquid.

The following examples further illustrate the invention.

### Example 1:

An approximately 30% solution of AB-16 [N,N'-bis(4- methylphenyl)-N,N'-bis(4-ethylphenyl)-[1,1'-(3,3'- dimethyl)biphenyl]-4,4'-diamine], a hole transporting small molecule synthesized by Fuji-Xerox, in butanedioldivinyl ether was prepared by gentle heating. A small quantity of di(i- butylphenyl) iodinium hexafluoroarsenate initiator was added to the solution. The clear solution was then coated on a standard selenium-coated-aluminium plate and then cured in a UV oven, thus forming a photoreceptor having a transport layer. The formed transport layer of the photoreceptor was transparent and colorless. The coated and cured film was about 8 µm thick.

The photoreceptor was then tested on a flat plate scanner having 100 charge-discharge cycles. The results of 100 cycles of electrical testing are given in Table 1. The meaning of the measured voltages are: V₀ is the initial potential after charging, V_{ddp} is the potential after 0.5 sec in the dark; V_{bg} is the potential after exposure to light; Vᵣ is the residual potential after exposure to a strong erase light; V_{cp} is the useful contrast voltage between the exposed and unexposed regions of this photoreceptor. A per cent discharge for a photoreceptor of at least 50% is acceptable, greater than 80% is excellent. This photoreceptor had a 98% discharge. The photoreceptor properties remained constant over 100 cycles.

**Table 1**

| | |
|---|---|
| V₀ | -141.5 |
| V_{ddp} | -128.5 |
| V_{bg} | 10.0 |
| Vᵣ | 11.5 |
| V_{cp} | -138.5 |
| % discharge | 98 |

### Example 2:

The procedure of Example 1 was repeated except a 60% AB-16, 40% bisphenol-A siloxy copolymer was used in place of the AB-16 of Example 1. The coated and cured film was about 10 µm thick. This photoreceptor had a high per cent discharge, although the charge acceptance decreased with the rapid cycling. The initial photoreceptor electrical properties are shown in Table 2.

**Table 2**

| | |
|---|---|
| V₀ | -213.0 |
| V_{ddp} | -195.0 |
| V_{bg} | -16.5 |
| Vᵣ | -14.0 |
| V_{cp} | -178.5 |
| % discharge | 84 |

## Claims

1. A process for preparing a photoreceptor having a charge generating layer and a charge transport layer deposited in this order on a substrate, characterized in that the process comprises the steps of :
a) dissolving an aromatic amine charge transport material and a cationic photoinitiator in a curable liquid monomer or a mixture of curable liquid monomers, said monomer(s) subjecting only to addition polymerization in the presence of a cationic initiator,
b) coating the obtained coating solution on the charge generating layer deposited on a substrate, and
c) photochemically curing said coating solution such that said monomer(s) form a polymer that is miscible with said aromatic amine charge transport material.

2. A process in accordance with Claim 1, wherein said aromatic amine charge transporting material is a charge transporting molecule.

3. A process in accordance with Claim 1, wherein said aromatic amine charge transporting material is a charge transporting polymer.

4. A process in accordance with Claim 1, wherein said curable liquid monomer is selected from the group consisting of epoxides, alkoxy styrenes, acrylates, methacrylates, and vinyl ethers.

5. A process in accordance with Claim 2, wherein said molecule is N,N'- bis(4-methylphenyl)-N,N'-bis(4-ethylphenyl)-[1,1'-(3,3'- dimethyl)biphenyl]-4,4'-diamine.

6. A process in accordance with Claim 3, wherein said polymer is a N,N'-diphenyl-N,N'-bis(3-methylphenyl)1,1'-diphenyl-4,4'-diamine/bisphenol-A siloxy copolymer.

7. A process in accordance with Claim 3, wherein said polymer is a m- N,N,N',N'-tetraphenyl biphenyl diamine/bisphenol-A siloxy copolymer.

8. A process in accordance with Claim 4, wherein said curable liquid monomer is butanedioldivinyl ether.

## Patentansprüche

1. Verfahren zur Herstellung eines Lichtempfängers mit einer ladungserzeugenden Schicht und einer Ladungstransportschicht, die in dieser Reihenfolge auf einem Substrat abgeschieden sind, dadurch gekennzeichnet, daß das Verfahren die Schritte umfaßt:
(a) Lösen eines Aromatenamin-Ladungstransportmaterials und eines kationischen Photoinitiators in einem härtbaren flüssigen Monomer oder einer Mischung aus härtbaren flüssigen Monomeren, wobei das/die Monomer(e) erst in Gegenwart eines kationischen Initiators eine Additionspolymerisation eingeht(en);
(b) Aufbeschichten der erhaltenen Beschichtungslösung auf die auf einem Substrat abgeschiedene ladungserzeugende Schicht, und
(c) photochemische Härtung der Beschichtungslösung in einer Weise, daß das/die Monomer(e) ein Polymer bildet(n), das mit dem Aromatenamin-Ladungstransportmaterial mischbar ist.

2. Verfahren nach Anspruch 1, wobei das Aromatenamin-Ladungstransportmaterial ein ladungstransportierendes Molekül ist.

3. Verfahren nach Anspruch 1, wobei das Aromatenamin-Ladungstransportmaterial ein ladungstransportierendes Polymer ist.

4. Verfahren nach Anspruch 1, wobei das härtbare flüssige Monomer aus der Gruppe bestehend aus Epoxiden, Alkoxystyrolen, Acrylaten, Methacrylaten und Vinylethern ausgewählt ist.

5. Verfahren nach Anspruch 2, wobei das Molekül N,N'-Bis-(4-methylphenyl)-N,N'-bis(4-ethylphenyl)-[1,1'-(3,3'-dimethyl)biphenyl]-4,4'-diamin ist.

6. Verfahren nach Anspruch 3, wobei das Polymer ein N,N'-Diphenyl-N,N'-bis(3-methylphenyl)-1,1'-diphenyl-4,4'-diamin/Bisphenol A-Siloxy-Copolymer ist.

7. Verfahren nach Anspruch 3, wobei das Polymer ein m-N,N,N',N'-Tetraphenylbiphenyldiamin/Bisphenol A-Siloxy-Copolymer ist.

8. Verfahren nach Anspruch 4, wobei das härtbare flüssige Monomer Butandioldivinylether ist.

## Revendications

1. Procédé de préparation d'un photorécepteur ayant une couche de génération de charge et une couche de transport de charge déposées dans cet ordre sur un substrat, caractérisé en ce que le procédé comprend les étapes consistant à :
a) dissoudre un matériau de transport de charge de type amine aromatique et un photoamorceur cationique dans un monomère liquide durcissable ou un mélange de monomères liquides durcissables, le ou lesdits monomère(s) subissant uniquement une polymérisation par addition en présence d'un amorceur cationique,
b) déposer la solution de revêtement obtenue sous la forme d'un revêtement sur la couche de génération de charge déposée sur un substrat, et
c) durcir photochimiquement ladite solution de revêtement de façon à ce que le ou lesdits monomère(s) forme(nt) un polymère qui soit miscible avec ledit matériau de transport de charge de type amine aromatique.

2. Procédé selon la revendication 1, dans lequel ledit matériau de transport de charge de type amine aromatique est une molécule de transport de charge.

3. Procédé selon la revendication 1, dans lequel ledit matériau de transport de charge de type amine aromatique est un polymère de transport de charge.

4. Procédé selon la revendication 1, dans lequel ledit monomère liquide durcissable est choisi dans le groupe constitué par des époxydes, des alcoxystyrènes, des acrylates, des méthacrylates et des éthers-oxydes vinyliques.

5. Procédé selon la revendication 2, dans lequel ladite molécule est la N,N'-bis(4-méthylphényl)-N,N'-bis(4-éthylphényl)-[1,1'-(3,3'-diméthyl)biphényl]-4,4'-diamine.

6. Procédé selon la revendication 3, dans lequel ledit polymère est un copolymère N,N'-diphényl-N,N'-bis(3-méthylphényl)-1,1'-diphényl-4,4'-diamine/bisphénol-A-siloxy.

7. Procédé selon la revendication 3, dans lequel ledit polymère est un copolymère m-N,N,N',N'-tétraphénylbiphényldiamine/bisphénol-A-siloxy.

8. Procédé selon la revendication 4, dans lequel ledit monomère liquide durcissable est l'éther-oxyde divinylique du butanediol.
